# EUROPÄISCHE PATENTSCHRIFT

(11) **EP 1 557 969 B1**
(45) Veröffentlichungstag und Bekanntmachung des Hinweises auf die Patenterteilung: **01.08.2007**
(21) Anmeldenummer: 05008881.4
(22) Anmeldetag: 13.03.1999
(51) Int. Cl.: H04L 5/04, H03M 5/16, G11B 7/125

(54) **Amplitudenmultiplexierung von digitalen Signalen**
Amplitude multiplexing of digital signals
Multiplexage en amplitude de signaux numériques

(30) Priorität: 03.04.1998 DE 19815011
(43) Veröffentlichungstag der Anmeldung: 27.07.2005
(62) Teilanmeldung aus: 99105208.5
(73) Patentinhaber: ATMEL Germany GmbH, 74072 Heilbronn (DE)
(72) Erfinder: Knotz, Herbert, Ing., 89155 Erbach (DE)

(56) Entgegenhaltungen:
- EP-A- 0 059 395
- DE-A- 4 035 996
- US-A- 4 280 221
- US-A- 5 510 919
- US-A- 5 600 634
- PATENT ABSTRACTS OF JAPAN Bd. 009, Nr. 310 (E-364), 6. Dezember 1985 (1985-12-06) & JP 60 144051 A (FUJITSU KK), 30. Juli 1985 (1985-07-30)
- PATENT ABSTRACTS OF JAPAN Bd. 005, Nr. 063 (E-054), 28. April 1981 (1981-04-28) & JP 56 013850 A (FUJITSU LTD), 10. Februar 1981 (1981-02-10)

## Beschreibung

Die Erfindung betrifft ein Verfahren gemäß dem Oberbegriff des Patentanspruchs 1.

In der Schaltungstechnik ergibt sich häufig die Notwendigkeit, mehrere digitale Sendesignale gleichzeitig von einer Sendeeinheit zu einer Empfangseinheit zu übertragen. Üblicherweise wird in einem derartigen Fall für jedes digitale Sendesignal eine Signalleitung als Übertragungsmedium benötigt. Dies führt insbesondere bei der Signalübertragung zwischen integrierten Schaltkreisen zu einem erheblichen Verdrahtungsaufwand und somit zu hohen Herstellungskosten.

Eine Übertragung von binären Signalen durch Amplitudenselektion ist beispielsweise aus der DE 40 35 996 bekannt.

Aus JP 60-144051, veröffentlicht am 30.7.1985, ist eine Schaltung bekannt, bei der aus einer UND-Verknüpfung aus einem Datensignal und einem invertiertem Taktsignal ein Zwischensignal gebildet wird, welches dem invertierenden Eingang eines Differenzverstärkers zugeführt wird. Dem nicht-invertierenden Eingang des Differenzverstärkers wird das Taktsignal selbst zugeführt.

Der Erfindung liegt die Aufgabe zugrunde, ein Verfahren gemäß dem Oberbegriff des Patentanspruchs 1 anzugeben, das mit einfachen Schaltungsmitteln durchführbar ist und das die Übertragung von digitalen Signalen über eine geringe Anzahl von Signalleitungen ermöglicht.

Die Aufgabe wird erfindungsgemäß durch die kennzeichnenden Merkmale des Patentanspruchs 1 gelöst. Vorteilhafte Ausgestaltungen und Weiterbildungen ergeben sich aus den Unteransprüchen.

Der erfindungswesentliche Gedanke liegt darin, aus den zu übertragenden digitalen Sendesignalen ein Mehrpegelsignal mit mehreren äquidistant beabstandeten logischen Signalpegel zu generieren, das über eine Signalleitung von der Sendeeinheit zur Empfangseinheit übertragen wird und dort durch Amplitudenfilterung in den digitalen Sendesignalen entsprechende digitale Empfangssignale zerlegt wird. Hierzu wird das Mehrpegelsignal in der Empfangseinheit mit zwischen den möglichen logischen Signalpegeln liegenden Vergleichsschwellen verglichen, wobei als Vergleichsergebnis die digitalen Empfangssignale gebildet werden. Aufgrund der äquidistant beabstandeten Signalpegel des Mehrpegelsignals wird eine optimale Ausnutzung des Dynamikbereichs und ein günstiges Rauschverhalten gewährleistet. Ferner werden die digitalen Sendesignale aus einem Taktsignal und einem dazu synchronen seriellen Datensignal, d.h. aus einem Signal, das in zum Taktsignal synchronen Bitzellen Bitinformationen enthält, sowie ggf. aus einem Datenfreigabesingal, welches die Gültigkeit des Datensignals markiert, abgeleitet. Dabei wird durch logische Verknüpfungen sichergestellt, dass vor der Summation der digitalen Sendesignale Teilbereiche des Datensignals durch das Taktsignal und ggf. Teilbereiche des Datenfreigabesignals durch das Taktsignal oder Teilbereiche des Taktsignals durch das Datenfreigabesignal ausgeblendet werden.

Hierdurch erreicht man, dass mit Ausnahme eines der Sendesignale, jedes der verbliebenden Sendesignale nur bei einem aktiven Signalpegel eines der anderen Sendesignale seinen aktiven Signalpegel annehmen kann, wobei jedes der Sendesignale entweder einen High-Pegel oder einen Low-Pegel als aktiven Signalpegel aufweisen kann. Falls eines der Sendesignale ein low-aktives Signal ist, d.h. einen Low-Pegel als aktiven Signalpegel aufweist, dann wird dieses Sendesignal zur Bildung des Mehrpegelsignals in der Sendeeinheit mit negativem Vorzeichen den anderen Sendesignalen hinzuaddiert. Auf der Empfangsseite werden nach der Signalübertragung aus den digitalen Empfangssignalen das Taktsignal, das Datensignal und ggf. das Datenfreigabesignal regeneriert. Um aus dem Taktsignal resultierende Störungen zu vermeiden, wird letzteres vorteilhafterweise nur während der Datenübertragung bereitgestellt.

Ein bevorzugter Anwendungsfall des Verfahrens ist die Signalübertragung über flexible Leitungen zwischen einer Sendeeinheit und einer relativ zur Sendeeinheit bewegbaren Empfangseinheit. Ein derartiger Anwendungsfall ist beispielsweise die Ansteuerung eines in einem Laufwerk für wiederbeschreibbare optische Speicherplatten über die Speicherplatte bewegbaren Laserdiodentreibers. Bei der erfindungsgemäßen Umsetzung des Verfahrens werden das Datensignal, das Taktsignal und das Datenfreigabesignal zur Einstellung verschiedener Parameter eines Laserdiodentreibers, z.B. der Laserleistung für verschiedene Betriebsarten eingesetzt, und ein Schreibsignal, ein Lesesignal und ein Löschsignal zur Steuerung der Laserleistung in den verschiedenen Betriebsarten, insbesondere in den Betriebsarten "Schreiben", "Lesen" und "Löschen", eingesetzt. Auf der Empfangsseite werden dem Schreib-, Lese- und Löschsignal entsprechende Empfangssignale gebildet, die Empfangssignale mit jeweils einem Gewichtungsfaktor gewichtet und nach der Gewichtung zu einem Steuersignal für eine Laserdiode summiert. Das Verfahren ermöglicht somit. Sowohl die Übertragung von Amplitudeninformationen, d. h. der Laserleistung für die verschiedenen Betriebsarten, als auch die Übertragung von beliebigen Zeitinformationen, die in den Pulsbreiten des Schreib-, Lese- oder Löschsignals enthalten sind.

Vorteilhafterweise wird ein Mehrpegelsignal aus dem Schreibsignal, dem Löschsignal und dem Lesesignal gebildet oder es werden zwei Mehrpegelsignale aus dem Schreibsignal, dem Lesesignal, dem Löschsignal, dem Taktsignal, dem Datensignal und dem Datenfreigabesignal gebildet, die dann auch über zwei Signalleitungen von einer Steuereinheit, d. h. von der Sendeeinheit, zum Laserdiodentreiber, d. h. zur Empfangseinheit, übertragen werden. Vorzugsweise werden das Datensignal gleichzeitig mit dem Datenfreigabesignal und dem Taktsignal und das Schreibsignal gleichzeitig mit dem das Löschsignal jedoch jeweils in unterschiedlichen Zeitfenstern , d. h. im Zeitmultiplex, über die eine Signalleitung und ein Schreibfreigabesignal, das ein Zeitfenster markiert, in dem das Schreib- und Löschsignal übertragen werden, sowie das Lesesignal als weiteres Mehrpegelsignal über die weitere Signalleitung zu Empfangseinheit übertragen.

Die Erfindung wird im folgenden anhand von Ausführungsbeispielen unterBezugnahme auf die Figuren näher beschrieben. Es zeigen:
- Figur 1: ein Schaltbild einer ersten Schaltungsanordnung zum Verständnis des erfindungsgemäßen Verfahrens,
- Figur 2: ein Schaltbild einer zweiten Schaltungsanordnung zur Durchführung des erfindungsgemäßen Verfahrens,
- Figur 3: Spannungs-Zeit-Diagramme verschiedener Signale aus der Schaltungsanordnung aus Figur 2,
- Figur 4: ein Schaltbild einer dritten Schaltungsanordnung zur Durchführung des erfindungsgemäßen Verfahrens,
- Figur 5: Spannungs-Zeit-Diagramme verschiedener Signale aus der Schaltungsanordnung aus Figur 4,
- Figur 6: ein Schaltbild einer vierten Schaltungsanordnung zur Duchführung des erfindungsgemäßen Verfahrens,
- Figur 7: Spannungs-Zeit-Diagramme verschiedener Signale aus der Schaltungsanordnung aus Figur 6,
- Figur 8: ein Schaltbild einer fünften Schaltungsanordnung zum Verständnis des erfindungsgemäßen Verfahrens,
- Figur 9: Spannungs-Zeit-Diagramme verschiedener Signale aus der Schaltungsanordnung aus Figur 8,
- Figur 10: ein Prinzipschaltbild einer sechsten Schaltungsanordnung zur Durchführung des erfindungsgemäßen Verfahrens.
- Figur 11: Spannungs-Zeit-Diagramme verschiedener Signale aus der Schaltungsanordnung aus Figur 10.

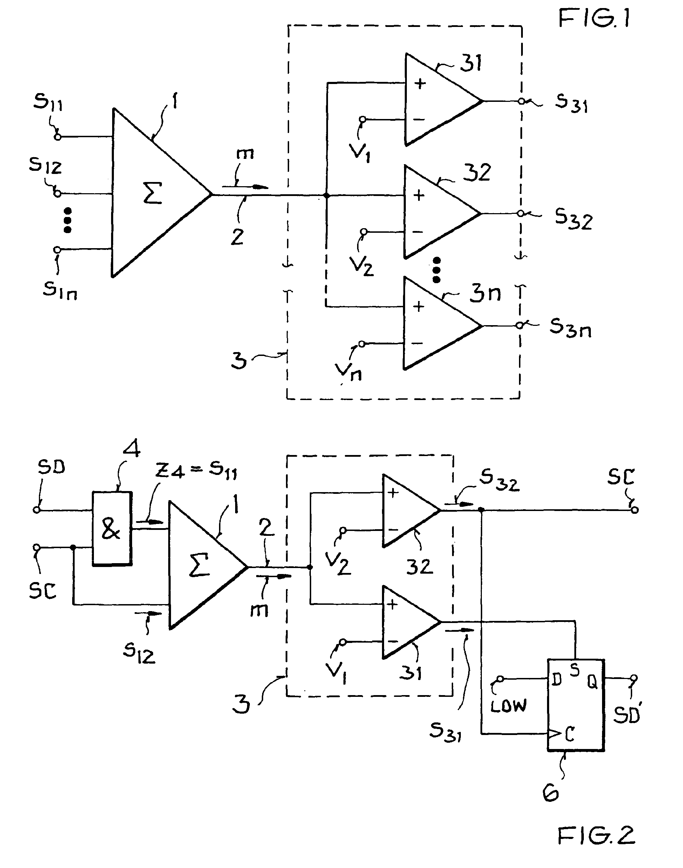

Gemäß Figur 1 werden die digitalen Sendesignale S₁₁, S₁₂ ... S₁ₙ in der Sendeeinheit 1 zum Mehrpegelsignal m summiert, welches über die Signalleitung 2 von der Sendeeinheit 1 zur Empfangseinheit 3 übertragen wird. Die Signalleitung 2 kann symmetrisch ausgeführt sein, d. h. zwei Drähte zur differentiellen Signalübertragung aufweisen, oder unsymmetrisch ausgeführt sein, d. h. einen Draht als Zuleitung und einen Draht als Bezugsleitung für ein Bezugspotential, beispielsweise für ein Masse- oder Versorgungspotential, aufweisen. Sie ist im vorliegenden Beispiel flexibel ausgeführt; des weiteren sind die Sendeeinheit 1 und die Empfangseinheit 3 auf unterschiedlichen Halbleiterchips integriert und können relativ zueinander bewegt werden. In der Empfangseinheit 3 ist zur Amplitudenfilterung für jedes der digitalen Sendesignale S₁₁, S₁₂ ... S₁ₙ ein Komparator 31 bzw. 32 bzw....3n vorgesehen, der das Mehrpegelsignal m mit jeweils einer zwischen zwei benachbarten logischen Signalpegeln des Mehrpegelsignals m liegenden Signalschwelle V₁ bzw. V₂ bzw. Vₙ vergleicht und als Vegleichsergebnis das dem jeweiligen digitalen Sendesignal S₁₁ bzw. S₁₂ bzw.... S₁ₙ entsprechende digitale Empfangssignal S₃₁ bzw. S₃₂ bzw.... S₃ₙ liefert. Die Abstände zwischen den logischen Signalpegeln des Mehrpegelsignals m sind im Wesentlichen gleich, so daß eine optimale Ausnutzung des Dynamikbereichs gewährleistet wird.

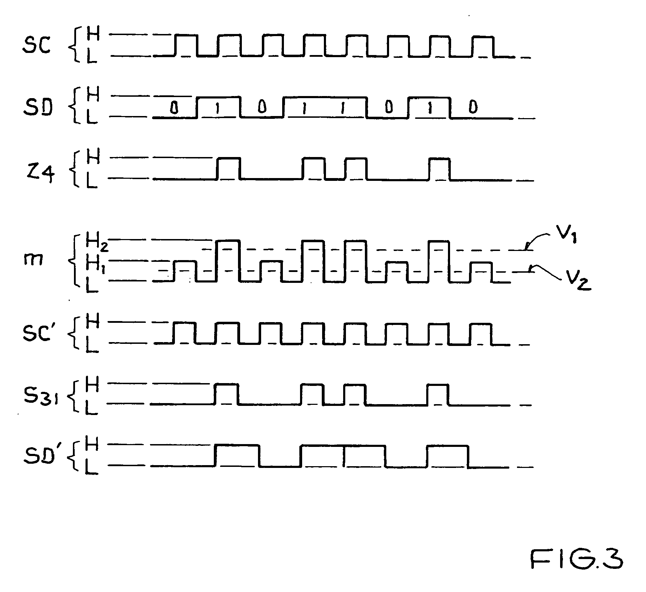

Gemäß Figur 2 werden Übertragung serieller digitaler Daten ein Taktsignals SC und ein zu diesem synchrones serielles Datensignal SD, das die Daten als Informationen enthält, mittels eines UND-Gatters 4 zu einem Zwischensignal Z₄, verknüpft, welches der Sendeeinheit 1 als erstes digitales Sendesignal S₁₁ zugeführt wird, Das Taktsignal SC wird der Sendeeinheit 1 als zweites digitales Sendesignal S₁₂ zugeführt. Figur 3 zeigt, daß durch die UND-Verknüpfung des Datensignals SD mit dem Taktsignal SC die einen High-Pegel H aufweisenden Bereiche des Datensignals SD durch das Taktsignal SC zur Hälfte ausgeblendet werden und daß die Bitinformation das Datensignals SD im so generierten Zwischensignal Z₄ erhalten bleibt, So daß das erste digitale Sendesignal S₁₁ nur bei einem High-Pegel H des zweiten digitalen Sendesiggnals S₁₂ einen High-Pegel annehmen kann. Das Zwischensignal Z₄ und das Taktsignal SC - letzteres wird die Sendeeinheit 1 als zweites digitales Sendesignals S₁₂ zugeführt - werden in der Sendeeinheit 1 zum Mehrpegelsignal m summiert, welches mit den Pegeln L, H₁ und H₂ drei logische Signalpegel aufweist. Das Mehrpegelsingal m wir über die Signalleitung 2 zur Empfangseinheit 3 übertragen und dort im ersten Komparator 31 mit der oberhalb des mittleren logische Signalpegels H₁ liegenden ersten Signalschwelle V₁ verglichen sowie im zweiten Komparator 32 mit der unterhalb des mittleren logischen Signalpegels H₁, liegenden zweiten Signalschwelle V₂ verglichen. Als Vergleichsergebnis liefert der erste Komparator 31 das dem ersten digitalen Sendesignal S₁₁ entsprechende erste digitale Empfangssignal S₃₁ und der zweite Komparator 32 das regenerierte Taktsignal SC', d.h. das dem zweiten digitalen Sendesignal S₁₂ entsprechende und dem Taktsignal SC gleiche zweite digitale Empfangssignal S₃₂. Das Datensignal SD wird auf der Empfangsseite mit dem D-Flip-Flop 6 regeneriert, dessen D-Eingang dauernd auf Low-Pegel liegt. Das Flip-Flop 6 wird mit einem High-Pegel des ersten digitalen Empfangssignals S₃₁ gesetzt und eine Taktperiode später mit der steigenden Flanke des zweiten digitalen Empfangssignals S₃₂ flankengesteuert rückgesetzt, so daß an seinem Ausgang Q das regenerierte Datensignal SD' abgegeben wird.

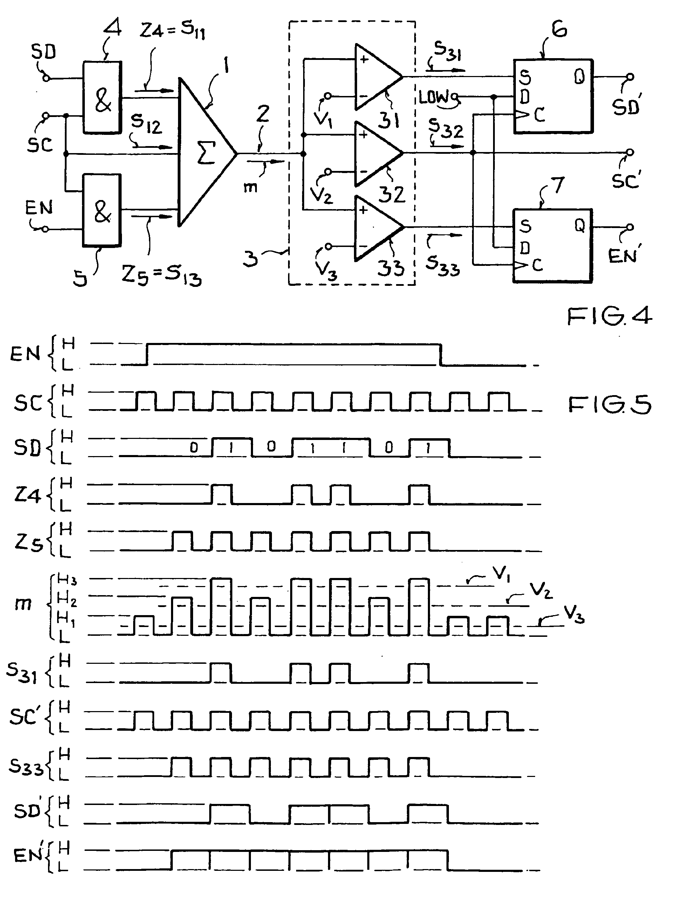

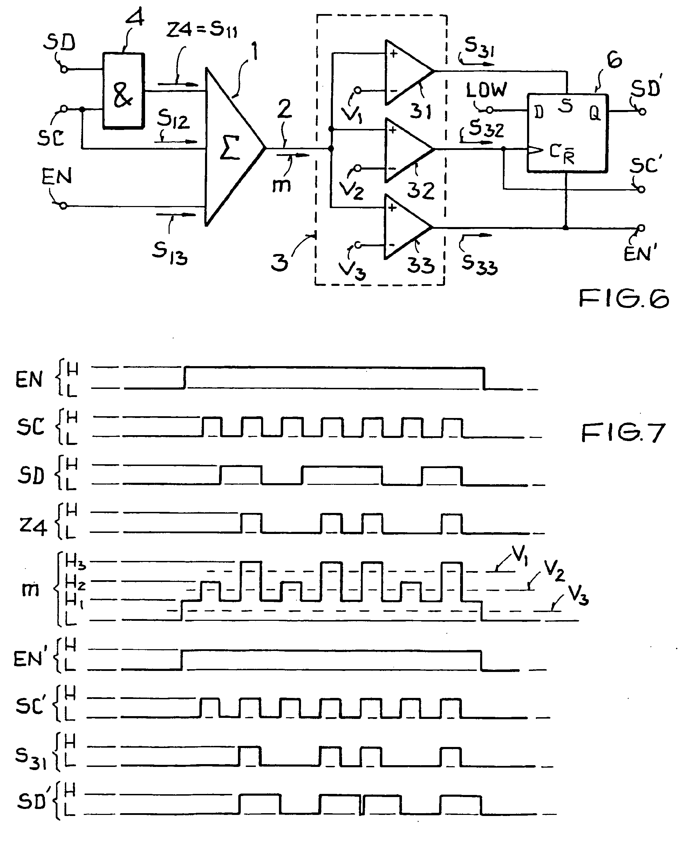

Die Schaltungsanordnung aus Figur 2 läßt sich mit einem weiteren UND-Gatter 5, einem weiteren Flip-Flop 7 und einem dritten Komparator 33 zu der in Figur 4 gezeigten Schaltungsanordnung ergänzen. Bei dieser Schaltungsanordnung wird zusätzlich um Taktsignal SC und Datensignal SD noch ein Datenfreigabesignal EN zur Bildung des Mehrpegelsignals m eingesetzt, wobei mit dem Datenfreigabesignal EN die Gültigkeit des Datensignals SD markiert und die Datenübertragung aktiviert wird. Das Taktsignals SC wird dabei dauernd übertragen. Mit dem weiteren UND-Gatter 5 werden das Datenfreigabesignal EN und das Taktsignal SC zu einem weiteren Zwischensignal Z₅ verknüpft, welches der Sendeeinheit 1 als drittes digitales Sendesignal S₁₃ zugeführt wird. Gemäß Figur 5 werden mit dem Taktsignal SC diejenigen Teilbereiche des Datensignals SD und des Datenfreigabesignals EN ausgeblendet, die mit einem Low-Pegel L des Taksignals SC einen High-Pegel H aufweisen. Das dritte digitale Sendesignal S₁₃ kann demnach nur bei einem High-Pegel des zweiten digitalen Sendesignals S₁₂ einen High-Pegel annehmen. Das durch Summation der drei digitalen Sendesignale S₁₁, S₁₂, S₁₃ gebildete Mehrpegelsignal m weist vier logische Signalpegel auf, und zwar die Pegel L, H₁, H₂ und H₃. In der Empfangseinheit 3 wird das Mehrpegelsignal m den drei Komparatoren 31, 32, 33 zugeführt. Der erste Komparator 31 vergleicht das Mehrpegelsignal m mit der zwischen den beiden höchsten logischen Signalpelgeln H₃ und H₂ des Mehrpegelsignals m liegenden Vergleichsschwelle V₁ und liefert als Vergleichsergebnis das dem ersten digitalen Sendesignal S₁₁ entsprechende und die Bitinformation des Datensignals SD enthaltende erste digitale Empfanssignal S₃₁; der zweite Komparator 32 vergleicht das Mehrpegelsignal m mit der zwischen den beiden niedrigsten logischen Signalpegeln L und H₂ des Mehrpegelsignals m liegenden Vergleichsschwelle V₂ und liefert als Vergleichsergebnis SC' das dem zweiten digitalen Sendesignal S₁₂ entsprechende und dem Taktsignal SC gleiche zweite digitale Empfangssignal S₃₂; der dritte Komparator 33 vergleicht schließlich das Mehrpegelsignal m mit der zwischen den beiden mittleren logischen Signalpegeln H₁ und H₂ des Mehrpegelsignals m liegenden Vergleichsschwelle V₃ und liefert als Vergleichsergebnis das dem dritten digitalen Sendesignal S₁₃ entsprechende dritte digitale Empfangssignal S₃₃. Das Datensignal SD wird ähnlich wie bei der Schaltungsanordnung aus Figur 2 mit dem 7 -Flip-Flop 6 regeneriert, welches mit dem High-Pegel H des ersten digitalen Empfangssignals S₃₁ gesetzt, d. h. pegelgesteuert gesetzt wird und eine Taktperiode später mit der steigenden Flanke des zweiten digitalen Empfangssignals S₃₂ flankengesteuert rückgesetzt wird. Entsprechend wird das Datenfreigabesignal EN mit dem weiteren Flip-Flop 7 regeneriert, welchesmit dem High-Pegel H des dritten digitalen Empfangssignals S₃₃ gesetzt und eine Taktperiode später mit der steigenden Flanke des zweiten digitalen Empfangssignals S₃₂ flankengesteuert rückgesetzt wird. Das regenerierte Datensignal DS' und das regenerierte Datenfreigabesignal EN' lassen sich mit in der Figur nicht gezeigten D-Flip-Flops, die gegenphasig zu den Flip-Flops 6 und 7 getaktet werden, weiter verarbeiten, um Signalspitzen, die aufgrund von Laufzeitunterschieden entstehen können, zu unterdrücken.

Figur 6 zeigt eine Weiterbildung der Schaltungsanordnung aus Figur 2, die sich von der Schaltungsanordnung gemäß Figur 2 dadurch unterscheidet, daß der Sendeeinheit 1 neben dem dem Zwischensignal Z₄ gleichen ersten digitalen Sendesignal S₁₁ und neben dem dem Taktsignal SC gleichen zweiten digitalen Sendesignal S₁₂ noch ein drittes digitales Sendesignal S₁₃ zugeführt wird, das gleich dem Datenfreigabesignal EN ist, mit welchem die Gültigkeit des Datensignal SD markiert wird, und daß das Datenfreigabesignal EN in der Empfangseinheit 3 mit einem dritten Komparator 33 regeneriert wird. Gemäß Figur 7 liegt das Taktsignal SC nur während der Datenübertragung an. Daher werden aus dem Taktsignal SC resultierende Störungen weitgehend vermieden. Das Datensignal SD und das Taktsignal SC weisen nur bei einem High-Pegel H des Datenfreigabesignals EN einen High-Pegel auf. Dieses kann ggf. durch eine Signalvorverarbeitung, bei der das Datensignal SD und das Taktsignal SC jeweils mit dem Datenfreigabesignals EN UND verknüpft werden, erreicht werden. Mit dem UND-Gatter 4, dass das Datensignal SD und das Taktsignal SC zum Zwischensignal Z₄ verknüpft, wird sichergestellt, daß das dem Zwischensignal Z₄, gleiche erste digitale Sendesignal S₁₁ nur bei einem High-Pegel des Taktsignals SC einen High-Pegel annehmen kann. In der Sendeeinheit 1 werden die digitalen Sendesignale S₁₁, S₁₂, S₁₃ zu dem Mehrpegelsignal m mit den vier logischen Signalpegeln L, H₁, H₂ und H₃ summiert. In der Empfangseinheit 3 wird das Mehrpegelsignal m den drei Komparatoren 31, 32, 33 zugeführt. Der erste Komparator 31 vergleicht das Mehrpegelsignal m mit der zwischen den beiden höchsten logischen Signalpegeln H₃ und H₂ des Mehrpegelsignals m liegenden Vergleichsschwelle V1 und liefert als Vergleichsergebnis das dem ersten digitalen Sendesignal S₁₁ entsprechende und die Bitinformation des Datensignals SD enthaltende erste digitale Empfangssignal S₃₁; der zweite Komparator 32 vergleicht das Mehrpegelsignal m mit de zwischen den beiden mittleren logischen Signalpegeln H₁ und H₂ des Mehrpegelisgnals m liegenden Vergleichsschwelle V₂ und liefert als Vergleichsergebnis SC' das dem zweiten digitalen Sendesignal S₁₂ entsprechende und dem Taktsignal SC gleiche zweite digitale Empfangssignal S₃₂; und der dritte Komparator 33 vergleicht schließlich das Mehrpegelsignal m mit der zwischen den beiden niedrigsten logischen Signalpegeln L und H₁ des Mehrpegelsignals m liegenden Vergleichsschwelle V₃ und liefert als Vergleichsergebnis EN' das dem dritten digitalen Sendesignal S₁₃ entsprechende und dem Datenfreigabesignal EN gleiche dritte digitale Empfangssignal S₃₃. Das Datensignal SD wird in gleicher Weise wie bei der Schaltungsanordnung aus Figur 2 mit dem Flip-Flop 6 regeneriert, welches mit dem High-Pegel H des ersten digitalen Empfanssignals S₃₁ gesetzt und eine Taktperiode später mit de steigenden Flanke des zweiten digitalen Empfangssignals S₃₂ flankengesteuert rückgesetzt wird. Das Flip-Flop 6 wird zusätzlich noch mit dem Low-Pegel L des dritten digitalen Empfangssignals S₃₃ taktunabhängig rückgesetzt.

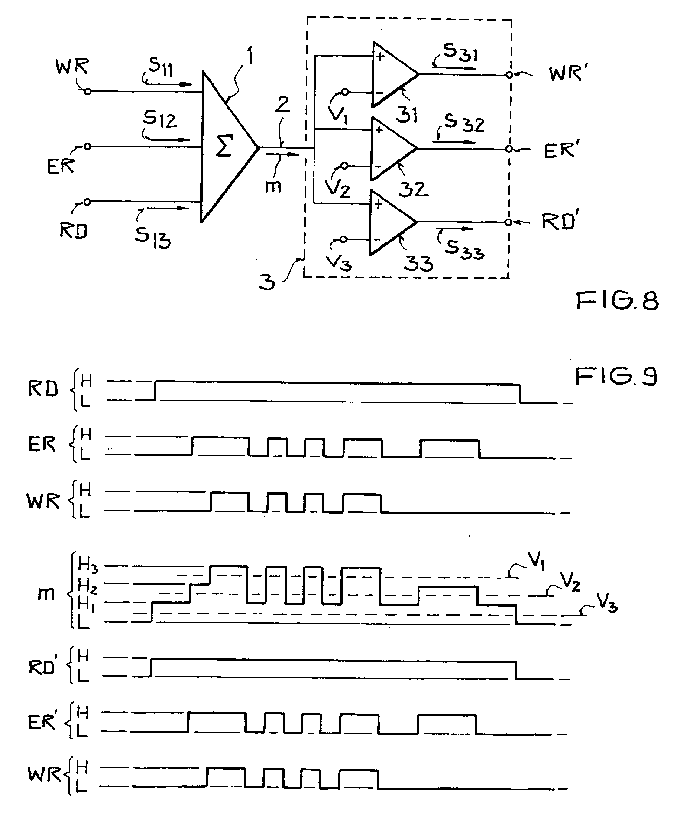

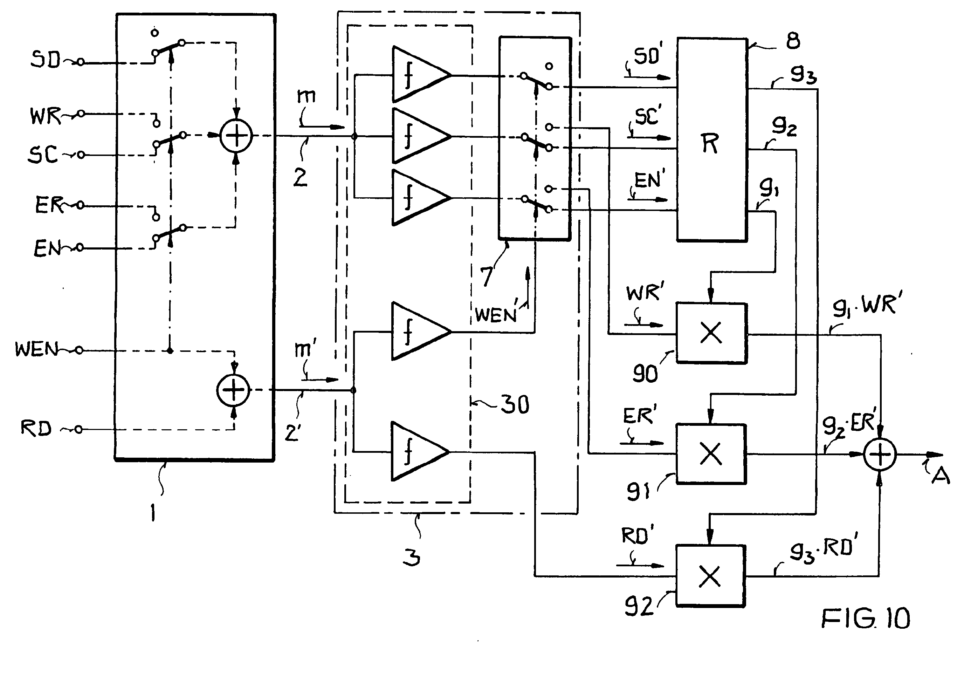

Die Schaltungsanordnung gemäß Figur 8 wird in einem Laufwerk für Speichermedien, insbesondere für wiederbeschreibare optische Speicherplatten, zur Übertragung eines Schreibsignals WR, eines Löschsignals ER und eines Lesesignals RD von der Sendeeinheit 1 über die Signalleitung 2 zur Empfangseinheit 3 eingesetzt. Mit dem Schreibsignal WR, das der Sendeeinheit 1 als erstes digitales Sendesignal S₁₁ zugeführt wird, wird dabei das Schreiben von Daten darstellenden Markierungen auf das Speichermedium gesteuert, mit dem Löschsignal ER, das der Sendeeinheit 1 zweites digitales Sendesignal S₁₂ zugeführt wird, wird das Löschen der Markierungen vom Speichermedium gesteuert und mit dem Lesesignal RD, das der Sendeeinheit 1 als drittes digitales Sendesignal S₁₃ zugeführt wird, wird das Lesen der Markierungen vom Speichermedium gesteuert. Unter Löschen wird hierbei da Schreiben einer einem vorgegebenen Bitwert, beispielsweise dem Bitwert 0 entsprechenden Markierungen verstanden. Bei einem Laufwerk für wiederbechreibbare optische Speicherplatten, beispielsweise für sogenannte DVD-RAMs, ist die Sendeeinheit 1 Teil einer das Laufwerk steuernden Steuereinheit und die Empfangseinheit 3 Teil eines in der Figur nicht gezeigten Laserdiodentreibers, der auf einem über die Speicherplatte bewegbaren Schreib-/Lösch-/Lesekopf angebracht ist und mit dem die optische Leistung einer Laserdiode entsprechend der gewünschten Aktion (Schreiben, Löschen oder Lesen) kontrolliert wird. Gemäß Figur 9 weist das Schreibsignal WR nur bei aktivem Löschsignal ER, d. h. bei einem High-Pegel H des Löschsignals ER, einen High-Pegel H auf. Des weiteren weist das Löschsignal ER nur bei einem High-Pegel des Lesesignal RD einen High-Pegel auf. Zur Übertragung des Lesesignals RD, des Löschsignals ER und des Schreibsignals WR werden diese in der Sendeeinheit 1 zu dem Mehrpegelsignal m mit den logischen Signalpegeln L, H₁, H₂ und H₃ summiert. Daraufhin wird das Mehrpegelsignal m über die Signalleitung 2 zur Empfangseinheit 3 übertragen und dort durch Amplitudenfilterung mit den Komperatoren 31, 32, 33 in die digitalen Empfangssignale S₃₁, S₃₂, S₃₃ zerlegt. Hierzu vergleicht der erste Komparator 31 das Mehrpegelsignal m mit der zwischen den beiden höchsten logischen Signalpegeln H₃ und H₂ des Mehrpegelsignals m liegenden Vergleichsschwelle V₁ und liefert als Vergleichsergebnis WR' das dem ersten digitalen Sendesignal S₁₁ entsprechende und dem Schreibsignal WR gleiche erste digitale Empfangssignal S₃₁; der zweite Komparator 32 vergleicht das Mehrpegelsignal m mit der zwischen den beiden mittleren logischen Signalpegeln H₁ und H₂ des Mehrpegelsignals m liegenden Vergleichsschwelle V₂ und liefert als Vergleichsergebnis ER' das dem zweiten digitalen Sendesignal S₁₂ entsprechende und dem Löschsignals ER gleiche zweite digitale Empfangssignal S₃₂; und der dritte Komparator 33 vergleicht schließlich das Mehrpegelsignal m mit der zwischen den beiden niedrigsten logischen Signalpegeln L und H₁ des Mehrpegelsignals m liegenden Vergleichsschwelle V₃ und liefert als Vergleichsergebnis RD' das dem dritten digitalen Sendesignal S₁₃ entsprechende und dem Lesesignal RD gleiche dritte digitale Empfangssignal S₃₃.

Die Schaltungsanordnung aus Figur 10 zeigt eine Ausgestaltung der Schaltungsanordnung aus Figur 8, bei der das Schreibsignal WR, das Löschsignal ER, ein Schreibfreigabesignal WEN, das ein Zeitfenster markiert, in dem das Schreibsignal WR und Löschsignal ER übertragen werden, und das Lesesignal RD sowie das Taktsignal SC, das serielle Datensignal SD, dessen Bitinformationen in zum Taktsignal SC synchronen Bitzellen enthalten sind, und das Datenfreigabesignal EN, mit dem die Gültigkeit des Datensignals SD markiert wird, der Sendeeinheit 1 als digitale Sendesignale zugeführt werden, und bei der die Sendeeinheit 1 aus diesen Sendesignalen zwei Mehrpegelsignale m, m' erzeugt, die jeweils über eine der Signalleitungen 2, 2' zur Empfangseinheit 3 übertragen werden. Die Empfangseinheit 3 bildet daraufhin aus den beiden Mehrpegelsignalen m, m' die digitalen Empfangssignale WR', ER', WEN', SD', SC', EN', RD', die den digitalen Sendesignalen WR, ER, WEN, SD, SC, EN, RD entsprechen.

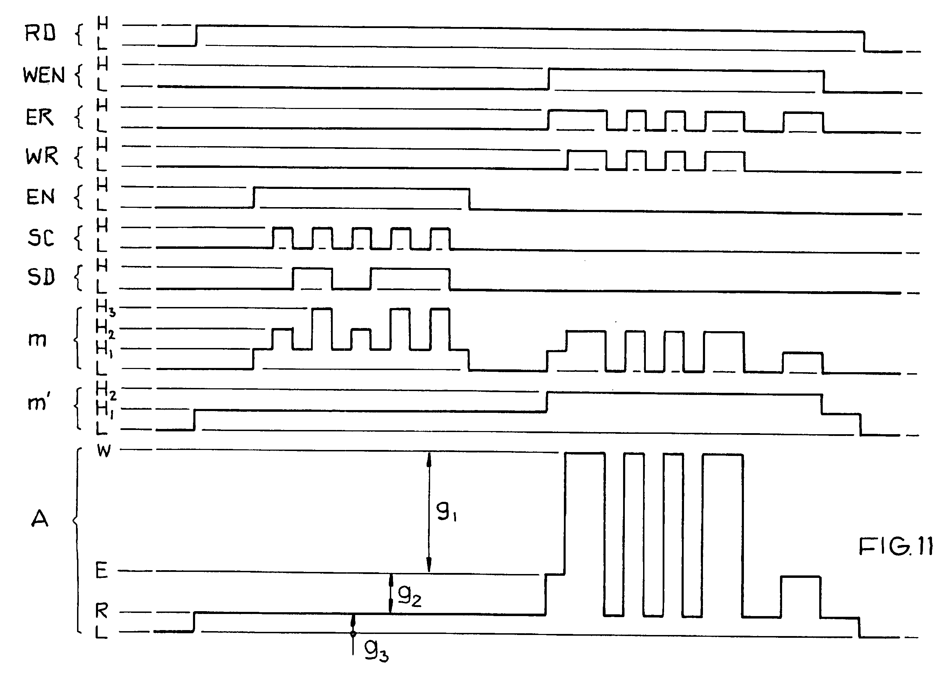

Gemäß Figur 11 weist das Lesesignal RD während der gesamten Signalübertragung und das Schreibfreigabesignal WEN während der Übertragung des Schreibsignals WR und des Löschsignals ER einen High-Pegel auf. In der Sendeeinheit 1 werden in einem ersten Zeitfenster das Taktsignal SC, Datensignal SD und das Datenfreigabesignal EN und in einem darauffolgenden Zeitfenster das Schreibsignal WR und Löschsignal ER zum Mehrpegelsignal zusammengefaßt, so daß letzteres, das über die Signalleitung 2 zur Empfangseinheit 3 übertragen wird, vier logische Signalpegel L, H₁, H₂ und H₃ aufweist, Das weitere Mehrpegelsignal m', das durch Summation des Lesesignals RD und des Schreibfreigabesignals WEN generiert wird und über die weitere Signalleitung 2' zur Empfangseinheit 3 übertragen wird, weist drei logische Signalpegel L, H₁ und H₂ auf. Um die Impulsverzerrungen des Mehrpegelsignals m möglichst gering zu halten, ist die Signalleitung 2 symmetrisch ausgeführt, die weitere Signalleitung 2' ist hingegen wegen den unkritischen Zeitanforderungen an das weitere Mehrpegelsignal m' oder das Lesesignal RD und Schreibfreigabesignal WEN einpolig ausgeführt.

In der Empfangseinheit 3 wird anhand des durch Amplitudenfilterung aus dem weiteren Mehrpegelsignal m' regenerierten Schreibfreigabesignals WEN' das Zeitfenster identifiziert, in dem das Mehrpegelsignal m die Information des Datensignals SD, Datenfreigabesignals EN und des Taktsignal SC bzw. des Schreibsignals WR und des Löschsignals ER enthält, so daß die dem Schreibsignal WR, dem Löschsignal ER, dem Datensignal SD, dem Datenfreigabesignal EN und dem Taktsignal SC entsprechenden Signalanteile aus dem Mehrpegelsignal m eindeutig identifiziert werden. Aus diesen Signalteilen werden dann die dem Schreibsignal WR, Löschsignal ER, Datensignal SD, Datenfreigabesignal EN und Taktsignal SC gleichen Empfangssignale WR' bzw. ER' bzw. SD' bzw. EN' bzw. SC' regeneriert. Das Datensignal SD, Datenfreigabesignal EN und Taktsignal SC werden hierbei gemäß dem Ausführungsbeispiel aus Figur 6 übertragen, denkbar ist aber auch eine Übertragung gemäß dem Ausführungsbeispiel aus Figur 4.

Auf der Empfangsseite werden mittels eines Amplitudenfilters 30 mit mehreren Komparatoren und mittels einer Decodierstufe 7 aus dem Mehrpegelsignal m die dem Datensignal SD, Datenfreigabesignal EN und Taktsignal SC entsprechenden Empfangssignale SD', EN' SC' gebildet. Diese Empfangssignale werden einem Register zugeführt, um die Bitinformationen des Datensignals SD, d. h. die übertragenen seriellen digitalen Daten, zwischenzuspeichern. Diese Daten stellen Gewichtungsfaktoren g1, g2, g3 dar, mit denen die dem Schreibsignal WR, dem Löschsignal ER und dem Lesesignal RD entsprechenden Empfangssignale ER', WR', RD' in den Gewichtungsstufen 90, 91, 92 zu den gewichteten Empfangssignalen g₁.WR', g₂^{.}ER' g₃^{.}RD' gewichtet, d.h. multipliziert, werden. Die gewichteten Empfangssignale g₁.WR', g₂^{.}ER', g₃^{.}RD' werden anschließend zum Steuersignal A summiert, mit dem die in der Figur nicht gezeigte Laserdiode des Laufwerks für optische Speichermedien angesteuert wird.

Das Steuersignal A weist mehrere Signalpegel auf L, R, E, W, deren Abstand durch die Gewichtungsfaktoren g₁, g₂, g₃ vorgegeben wird. Über die Signalleitung 2 werden somit sowohl Amplitudeninformationen als auch Zeitinformationen übertragen. Die Amplitudeninformationen werden dabei als serielle digitale Daten und die Zeitinformationen als Impulsbreiten des Schreibsignals WR, Lesesignals RD oder Löschsignals ER übertragen, wobei diese Impulsbreiten empfangsseitig nicht abgetastet werden und daher beliebige Werte aufweisen können, d. h. zur Übertragung analoger Informationen, beispielsweise zur Übertragung einer Referenzfrequenz zur Empfangseinheit, geeignet sind.

## Patentansprüche

1. Verfahren zur Übertragung von digitalen Sendesignalen zwischen einer Sendeeinheit (1) und mindestens einer Empfangseinheit (3), wobei in der Sendeeinheit (1) mindestens zwei digitale Sendesignale (s₁₁, s₁₂, ... s₁ₙ) zu einem Mehrpegelsignal (m) summiert werden, dass das Mehrpegelsignal (m) über eine Signalleitung (2) von der Sendeeinheit (1) zur Empfangseinheit (3) übertragen wird und dass in der Empfangseinheit (3) durch Amplitudenfilterung aus dem Mehrpegelsignal (m) den digitalen Sendesignalen (s₁₁, s₁₂, ... s₁ₙ) entsprechende digitale Empfangssignale (s₃₁, s₃₂, ..., s₃ₙ) gebildet werden,
**dadurch gekennzeichnet, dass** der Sendeeinheit (1) als erstes digitales Sendesignal (S₁₁) ein durch eine UND-Verknüpfung aus einem Taktsignal (SC) und einem seriellen, zum Taktsignal (SC) synchronen, Datensignal (SD) gebildetes Zwischensignal (z₄) zugeführt wird und als zweites digitales Sendesignal (s₁₂) das Taktsignal (SC) zugeführt wird.

2. Verfahren nach Anspruch 1, **dadurch gekennzeichnet, dass** das Datensignal (SD) empfangsseitig mit einem Flip-Flop (6) regeneriert wird, welches mit dem dem ersten digitalen Sendesignal (s₁₁) entsprechenden digitalen Empfangssignal (s₃₁) gesetzt und mit dem dem zweiten digitalen Sendesignal (s₁₂) entsprechenden digitalen Emfpangssignal (s₃₂) flankengesteuert rückgesetzt wird.

3. Verfahren nach Anspruch 1, **dadurch gekennzeichnet, dass** der Sendeeinheit (1) als ein drittes digitales Sendesignal (S₁₃) ein die Gültigkeit des Datensignals (SD) markierendes Datenfreigabesignal (EN) zugeführt wird.

4. Verfahren nach Anspruch 3, **dadurch gekennzeichnet, dass** das Datensignal (SD) empfangsseitig mit einem Flip-Flop (6) regeneriert wird, welches mit dem dem ersten digitalen Sendesignal (s₁₁) entsprechenden digitalen Empfangssignal (s₃₁) gesetzt, mit dem dem zweiten digitalen Sendesignal (s₁₂) entsprechenden digitalen Empfangssignal (s₃₂) flankengesteuert rückgesetzt und mit dem dem dritten digitalen Sendesignal (s₁₃) entsprechenden digitalen Empfangssignal (s₃₃) pegelgesteuert rückgesetzt wird.

5. Verfahren nach Anspruch 1, **dadurch gekennzeichnet, dass** der Sendeeinheit (2) als drittes digitales Sendesignal (s₁₃) ein durch eine UND-Verknüpfung aus dem Taktsignal (SC) und einem Datenfreigabesignal (EN) gebildetes weiteres Zwischensignal (z₅) zugeführt wird.

6. Verfahren nach Anspruch 5, **dadurch gekennzeichnet, dass** das Datensignal (SD) empfangsseitig mit einem Flip-Flop (6) regeneriert wird, welches mit dem dem ersten digitalen Sendesignal (s₁₁) entsprechenden digitalen Empfangssignal (sS₃₁) gesetzt und mit dem dem zweiten digitalen Sendesignal (s₁₂) entsprechenden digitalen Empfangssignal (s₃₂) flankengesteuert rückgesetzt wird und dass das Datenfreigabesignal (EN) empfangsseitig mit einem weiteren Flip-Flop (7) regeneriert wird, welches mit dem dem dritten digitalen Sendesignal (s₁₃) entsprechenden digitalen Empfangssignal (s₃₃) gesetzt und mit dem dem zweiten digitalen Sendesignal (s₁₂) entsprechenden digitalen Empfangssignal (s₃₂) flankengesteuert rückgesetzt wird.

7. Verwendung des Verfahrens nach einem der vorherigen Ansprüche zur Übertragung serieller digitaler Daten von der Sendeeinheit (1) zur Empfangseinheit (3).

## Claims

1. Method of transmitting digital transmitted signals between a transmitting unit (1) and at least one receiving unit (3), wherein at least two digital transmitted signals (s₁₁, s₁₂, ... s₁ₙ) are summated in the transmitting unit (1) to form a multilevel signal (m), that the multilevel signal (m) is transmitted by way of a signal line (2) from the transmitting unit (1) to the receiving unit (3) and that digital received signals (s₃₁, s₃₂, ... s₃ₙ) corresponding with the digital transmitted signals (s₁₁, s₁₂, ... s₁ₙ) are formed in the receiving unit (3) by amplitude filtration from the multilevel signal (m), **characterised in that** an intermediate signal (z₄) formed by an AND linking of a clock signal (SC) and a serial data signal (SD) synchronous with the clock signal (SC) is fed as first digital transmitted signal (s₁₁), and the clock signal (SC) is fed as second digital transmitted signal (s₁₂), to the transmitting unit (1).

2. Method according to claim 1, **characterised in that** the data signal (SD) is regenerated at the reception side by a flip-flop (6), which is set by the digital received signal (s₃₁) corresponding with the first digital transmitted signal (s₁₁) and is reset in flank-controlled manner by the digital received signal (s₃₂) corresponding with the second digital transmitted signal (s₁₂).

3. Method according to claim 1, **characterised in that** the transmitting unit (1) is fed, as a third digital transmitted signal (s₁₃), a data release signal (EN) marking the validity of the data signal (SD).

4. Method according to claim 3, **characterised in that** the data signal (SD) is regenerated at the reception side by a flip-flop (6), which is set by the digital received signal (s₃₁) corresponding with the first digital transmitted signal (s₁₁) and is reset in flank-controlled manner by the digital received signal (s₃₂) corresponding with the second digital transmitted signal (s₁₂) and is reset in level-controlled manner by the digital received signal (s₃₃) corresponding with the third digital transmitted signal (s₁₃).

5. Method according to claim 1, **characterised in that** a further intermediate signal (z₅) formed by an AND linking of the clock signal (SC) and a data release signal (EN) is fed as third digital signal (s₁₃), to the transmitting unit (2).

6. Method according to claim 5, **characterised in that** the data signal (SD) is regenerated at the reception side by a flip-flop (6), which is set by the digital received signal (s₃₁) corresponding with the first digital transmitted signal (s₁₁) and is reset in flank-controlled manner by the digital received signal (s₃₂) corresponding with the second digital transmitted signal (s₁₂) and that the data release signal (EN) is regenerated at the reception side by a further flip-flop (7), which is set by the digital received signal (s₃₃) corresponding with the third digital transmitted signal (s₁₃) and is reset in flank-controlled manner by the digital received signal (s₃₂) corresponding with the second digital transmitted signal (s₁₂).

7. Use of the method according to one of the preceding claims for transmission of serial digital data from the transmitting unit (1) to the receiving unit (3).

## Revendications

1. Procédé de transmission de signaux numériques d'émission entre une unité d'émission (1) et au moins une unité de réception (3), dans lequel on additionne dans l'unité d'émission (1) au moins deux signaux numériques d'émission (s₁₁, s₁₂, ... s₁ₙ) pour former un signal multiniveau (m), le signal multiniveau (m) est transmis de l'unité d'émission (1) vers l'unité de réception (3) par un canal de signaux (2), et des signaux de réception numériques (s_{31'} s_{32'} ... s₃ₙ) correspondant aux signaux numériques d'émission (s₁₁, s₁₂, ... s₁ₙ) sont formés dans l'unité de réception (3) par filtrage d'amplitude à partir du signal multiniveau (m),
**caractérisé en ce que** l'on transmet à l'unité d'émission (1), en tant que premier signal numérique d'émission (S₁₁), un signal intermédiaire (z₄) constitué par une liaison logique ET à partir d'un signal de synchronisation (SC) et d'un signal de données (SD) sériel, synchrone avec le signal de synchronisation (SC), et en tant que deuxième signal d'émission (s₁₂), le signal de synchronisation (SC).

2. Procédé selon la revendication 1, **caractérisé en ce que** le signal de données (SD) est régénéré à la réception par un flip-flop (6), qui est mis à l'état 1 par le signal de réception numérique (s₃₁) correspondant au premier signal d'émission numérique (s₁₁) et remis à zéro par commande par la pente d'impulsion du signal numérique de réception (S₃₂) correspondant au deuxième signal numérique d'émission (s₁₂).

3. Procédé selon la revendication 1, **caractérisé en ce que** l'on transmet à l'unité d'émission (1) en tant que troisième signal numérique d'émission (s₁₃) un signal de libération de données (EN) marquant la validité du signal de données (SD).

4. Procédé selon la revendication 3, **caractérisé en ce que** le signal de données (SD) est régénéré à la réception par un flip-flop (6) qui est mis à l'état 1 par le signal numérique de réception (s₃₁) correspondant au premier signal numérique d'émission (s₁₁), remis à zéro par commande par la pente d'impulsion du signal numérique de réception (S₃₂) correspondant au deuxième signal numérique d'émission (s₁₂) et remis à zéro par commande par le niveau du signal numérique de réception (s₃₃) correspondant au troisième signal numérique d'émission (s₁₃).

5. Procédé selon la revendication 1, **caractérisé en ce que** l'on transmet à l'unité d'émission (2) en tant que troisième signal numérique d'émission (s₁₃) un signal intermédiaire (z₅) supplémentaire constitué par une liaison logique ET à partir d'un signal de synchronisation (SC) et d'un signal de libération de données (EN).

6. Procédé selon la revendication 5, **caractérisé en ce que** le signal de données (SD) est régénéré à la réception par un flip-flop (6), qui est mis à l'état 1 par le signal numérique de réception (s₃₁) correspondant au premier signal numérique d'émission (s₁₁) et remis à zéro par commande par la pente d'impulsion du signal numérique de réception (S₃₂) correspondant au deuxième signal numérique d'émission (s₁₂) et **en ce que** le signal de libération de données (EN) est régénéré à la réception par un flip-flop supplémentaire (7), qui est mis à l'état 1 par le signal numérique de réception (s₃₃) correspondant au troisième signal numérique d'émission (s₁₃) et remis à zéro par commande par le niveau du signal numérique de réception (s₃₂) correspondant au deuxième signal numérique d'émission (s₁₂).

7. Utilisation du procédé selon l'une quelconque des revendications précédentes pour la transmission de données numériques sérielles de l'unité d'émission (1) vers l'unité de réception (3).
